# EUROPEAN PATENT APPLICATION

(11) **EP 4 071 281 A1**
(43) Date of publication of application: **12.10.2022**
(21) Application number: 20899980.5
(22) Date of filing: 08.12.2020
(51) Int. Cl.: C25D 5/02, C25D 5/54

(54) **METHOD FOR SURFACE METALLIZATION OF OSCILLATOR AND METALLIZED OSCILLATOR**

(30) Priority: 12.12.2019 CN 201911275278
(71) Applicant: ZTE Corporation, Shenzhen, Guangdong 518057 (CN)
(72) Inventor: LIU, Shuiping, Shenzhen, Guangdong 518057 (CN); KONG, Shengwei, Shenzhen, Guangdong 518057 (CN); LIAO, Ruikang, Shenzhen, Guangdong 518057 (CN); ZHANG, Chenzhao, Shenzhen, Guangdong 518057 (CN); TANG, Danli, Shenzhen, Guangdong 518057 (CN); MA, Chao, Shenzhen, Guangdong 518057 (CN)
(74) Representative: Zoli, Filippo
(86) International application number: PCT/CN2020/134557
(87) International publication number: WO 2021/115261

(57) **Abstract**

A method for surface metallization of an oscillator and a metallized oscillator. The method comprises: using an acid copper process to electroplate copper on a nickel layer in an electroplating zone of an oscillator body so as to form a thin copper layer in the electroplating zone (S110); etching the oscillator body to remove the nickel layer in a non-electroplating zone of the oscillator body (S120); performing copper electroplating on the thin copper layer in the electroplating zone to form a thick copper layer (S130); and performing tin electroplating on the thick copper layer in the electroplating zone to form a tin layer, and performing a tin protection treatment on the tin layer (S140).

## Description

### CROSS-REFERENCE TO RELATED APPLICATION

The present application is filed on the basis of the Chinese patent application No. 201911275278.9 filed on December 12, 2019, and claims the priority of the Chinese patent application, the entire contents of which are incorporated herein by reference.

### TECHNICAL FIELD

The present disclosure relates to the technical field of surface electroplating, and in particular to a method for surface metallization of an oscillator and a metallized oscillator.

### BACKGROUND

Metallization technique refers to making wires, graphics or mounting components with electrical functions on an injection-molded plastic shell to form a three-dimensional molded interconnection device. This technique has the following advantages in design: increased available space for a three-dimensional circuit carrier, smaller and lighter devices, more functions and greater design freedom. In addition, this technique has the following advantages in manufacturing: short manufacturing process, direct use of the shell as an interconnection carrier, reduced quantity and types of material put into manufacturing, good environment friendliness, easy discharging and less harmful substances discharge. However, the existing metallization technique may lead to overflow plating during electroplating, which may affect the electrical performance of a circuit.

### SUMMARY

The present disclosure provides a method for surface metallization of an oscillator and a metallized oscillator.

According to an embodiment of the present disclosure, provided is a method for surface metallization, including:
electroplating copper with acid copper on a nickel layer in an electroplating zone of an oscillator body to form a thin copper layer in the electroplating zone;
etching the oscillator body to remove the nickel layer in a non-electroplating zone of the oscillator body;
electroplating copper on the thin copper layer in the electroplating zone to form a thick copper layer; and
electroplating tin on the thick copper layer in the electroplating zone to form a tin layer, and performing a tin protection process on the tin layer.

According to another embodiment of the present disclosure, further provided is an oscillator body, including:
an injection-molded carrier, and an electroplating zone and a non-electroplating zone on the surface of the carrier.

### BRIEF DESCRIPTION OF DRAWINGS

The drawings described here are provided for a further understanding of the present disclosure, and constitute a part of the present disclosure. The illustrative embodiments of the present disclosure and their descriptions are used to explain the present disclosure and do not constitute an improper limitation to the present disclosure. In the drawings:
Fig. 1 is a flowchart of a method for surface metallization of an oscillator according to an embodiment of the present disclosure;

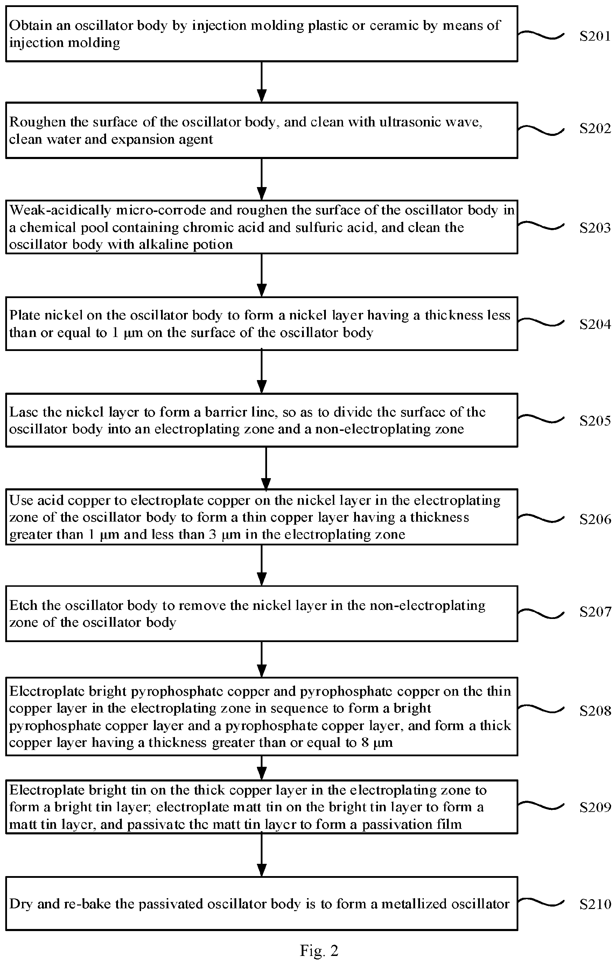

Fig. 2 is a flowchart of another method for surface metallization of an oscillator according to an embodiment of the present disclosure; and
Fig. 3 is a schematic structural diagram of a metallized oscillator according to an embodiment of the present disclosure.

### DETAILED DESCRIPTION

In order to make the objects, technical schemes and advantages of the present disclosure clear, embodiments of the present disclosure will be described in detail with reference to the drawings. It should be noted that the embodiments in the present disclosure and the features in the embodiments may be combined with each other at random without conflict.

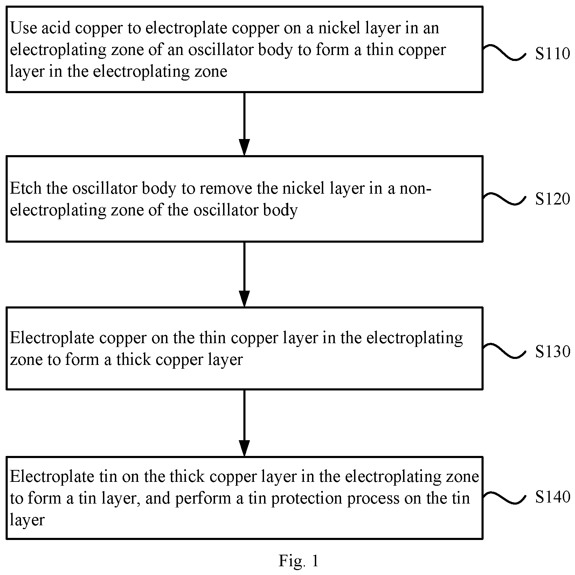

Fig. 1 is a flowchart of a method for surface metallization of an oscillator in an embodiment of the present disclosure. In an embodiment, the method may be used for metalizing the surface of a carrier such as plastics, ceramics or the like. As shown in Fig. 1, the method includes steps S110-S140.

In a step of S110, acid copper is used to electroplate copper on a nickel layer in an electroplating zone of an oscillator body to form a thin copper layer in the electroplating zone.

In a step of S120, the oscillator body is etched to remove the nickel layer in a non-electroplating zone of the oscillator body.

In a step of S130, copper is electroplated on the thin copper layer in the electroplating zone to form a thick copper layer.

In a step of S140, tin is electroplated on the thick copper layer in the electroplating zone to form a tin layer, and a tin protection process is performed on the tin layer.

In an embodiment, before electroplating copper with acid copper on a nickel layer in an electroplating zone of an oscillator body to form a thin copper layer in the electroplating zone, the method further includes following steps: obtaining an oscillator body by means of injection molding; physically roughening the oscillator body, and cleaning the physically roughened oscillator body; chemically roughening the oscillator body, and cleaning the chemically roughened oscillator body; depositing palladium ions on the surface of the chemically roughened oscillator body; plating nickel on the oscillator body to form a nickel layer on the surface of the oscillator body; and lasing on the nickel layer to form a barrier line, so as to divide the surface of the oscillator body into an electroplating zone and the non-electroplating zone.

The oscillator body may be made of plastic or ceramic. In an embodiment, a corresponding oscillator body may be made of reinforced polyphenylene sulfide containing metal particles or PPS modified material (PPS+40% glass fiber) by means of injection molding. This material has high finished product yield, stable injection molding, and is not prone to injection defects such as material missing, etc.

In an embodiment, physically roughening the surface of the oscillator body may be achieved by mechanically roughening the surface of the oscillator body with 60# to 80# white fused alumina to increase the surface roughness of the oscillator body. By adjusting the parameters such as spraying speed and air pressure of sandblasting equipment, the surface roughness of the oscillator body may meet use requirements, improve the adhesion of a subsequent coating, and prevent the coating from peeling and falling off.

In an embodiment, cleaning the physically roughened oscillator body may be as follows: cleaning the physically roughened oscillator body with ultrasonic wave, clean water and expansion agent in sequence. The oscillator body may be cleaned with ultrasonic wave and clean water, or may be cleaned with ultrasonic wave, clean water and expansion agent. The oscillator body is cleaned with ultrasonic wave first, then with clean water, and with expansion agent finally. The expansion agent may introduce more voids, so that metal ions may penetrate into these voids and are closely combined with the oscillator body, further increasing the adhesion of metal. Cleaning the physically roughened oscillator body may increase the hydrophilicity of the surface of the oscillator body, so as to ensure that metal surface activation may be uniformly performed on the surface.

In an embodiment, the process of chemically roughening the oscillator body and cleaning the chemically roughened oscillator body may be as follows: weak-acidically micro-corroding and roughening the oscillator body in a chemical pool containing chromic acid and sulfuric acid; and cleaning the chemically roughened oscillator body with alkaline potion. The chromic acid is neutralized to reduce hexavalent chromium to monovalent chromium. Chemical potion may increase the metal adsorption, which is conducive to the deposition of palladium ions.

In an embodiment, palladium ions may be deposited on the surface of the oscillator body by debonding.

In an embodiment, the nickel layer has a thickness less than or equal to 1 µm.

In an embodiment, when lasing on the nickel layer, laser engraving is performed at the position where the barrier line is to be formed, and the nickel layer at the position where the barrier line is to be formed is removed to form the barrier line, so that the surface of the oscillator body is divided into an electroplating zone and a non-electroplating zone. The barrier line has a width of at least 0.5 mm, and mainly falls in the non-electroplating zone, so as not to damage or reduce the predetermined shape or area of the electroplating zone.

In an embodiment, when performing laser engraving, a 3D laser engraving device equipped with a manipulator may be adopted to engrave a plurality of areas on the oscillator body that need engraving, and the laser engraving can be continually performed for an engraving line at a corner, without a dislocation.

In an embodiment, acid copper is used to electroplate copper on a nickel layer in an electroplating zone of an oscillator body to form a thin copper layer in the electroplating zone. Acid copper may dissolve excess nickel on the side of the electroplating zone, to prevent overflow plating, reduce surface roughness of a circuit, and improve the side flatness of a metal line, thus improving the electrical performance of the circuit. This is different from alkaline pyrophosphate copper process adopted in the traditional technique, in which: overflow plating may occur when metal is plated, and too thick copper layer may cause the plated copper to be conductive with the nickel layer which is not deplated, resulting in product connected and product rejection.

In an embodiment, when etching the oscillator body, all surfaces of the oscillator body are etched, the nickel layer having a thickness of 1 µm is removed, and a surface layer of the thin copper layer having a thickness of about 1 µm is also removed.

In an embodiment, the process of electroplating copper on the thin copper layer in the electroplating zone to form a thick copper layer may be as follows: electroplating bright pyrophosphate copper and pyrophosphate copper on the thin copper layer in the electroplating zone in sequence to form a bright pyrophosphate copper layer and a pyrophosphate copper layer so a thick copper layer consisted by the bright pyrophosphate copper layer and the pyrophosphate copper layer is formed.

The thick copper layer has a thickness greater than or equal to 8 µm.

In an embodiment, the method of electroplating tin on the thick copper layer in the electroplating zone to form a tin layer may be as follows: electroplating bright tin on the thick copper layer in the electroplating zone to form a bright tin layer; and electroplating matt tin on the bright tin layer to form a matt tin layer.

In an embodiment, the tin protection process performed on the tin layer may be as follows: passivating the matt tin layer to form a passivation film, so that the passivation film provides tin protection for the oscillator body.

In an embodiment, after the tin protection process performed on the tin layer, the method further includes following step: drying and re-baking the passivated oscillator body.

In an embodiment, as a further explanation of the above embodiments, the method includes following steps.

In a step of S201, an oscillator body is obtained by injection molding plastic or ceramic by means of injection molding.

In a step of S202, the surface of the oscillator body is roughened, and is cleaned with ultrasonic wave, clean water and expansion agent.

In a step of S203, the surface of the oscillator body is weak-acidically micro-corroded and roughened in a chemical pool containing chromic acid and sulfuric acid, and the oscillator body is cleaned with alkaline potion.

In a step of S204, nickel is plated on the oscillator body to form a nickel layer having a thickness less than or equal to 1 µm on the surface of the oscillator body.

In a step of S205, the nickel layer is lased to form a barrier line, so as to divide the surface of the oscillator body into an electroplating zone and a non-electroplating zone.

In a step of S206, acid copper is used to electroplate copper on the nickel layer in the electroplating zone of the oscillator body to form a thin copper layer having a thickness greater than 1 µm and less than 3 µm in the electroplating zone.

In a step of S207, the oscillator body is etched to remove the nickel layer in the non-electroplating zone of the oscillator body.

In a step of S208, bright pyrophosphate copper and pyrophosphate copper are electroplated on the thin copper layer in the electroplating zone in sequence to form a bright pyrophosphate copper layer and a pyrophosphate copper layer, so a thick copper layer having a thickness greater than or equal to 8 µm is formed.

In a step of S209, bright tin is electroplated on the thick copper layer in the electroplating zone to form a bright tin layer; matt tin is electroplated on the bright tin layer to form a matt tin layer, and the matt tin layer is passivated to form a passivation film.

In a step of S210, the passivated oscillator body is dried and re-baked to form a metallized oscillator.

In the method for surface metallization provided in an embodiment of the present disclosure, acid copper is used to electroplate copper on a nickel layer in an electroplating zone of an oscillator body to form a thin copper layer in the electroplating zone. Acid copper may dissolve excess nickel on side faces, prevent overflow plating, reduce surface line roughness, and improve the side flatness of a metal trace, thus improving the electrical performance of a circuit. In contrast, the traditional technique adopte alkaline pyrophosphate copper, overflow plating may occur when metal is plated, and too thick copper layer may cause the plated copper to be conductive with the nickel layer which is not deplated, resulting in product connection and product rejection.

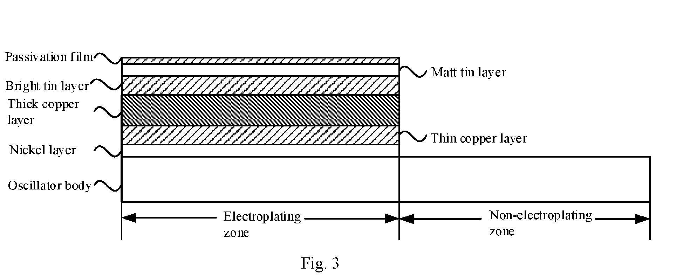

In an embodiment, Fig. 3 is a schematic structural diagram of a metallized oscillator in an embodiment of the present disclosure. The metallized oscillator is obtained by means of the above-mentioned method for surface metallization. As shown in Fig. 3, the metallized oscillator includes an injection-molded oscillator body, and an electroplating zone and a non-electroplating zone on the surface of the oscillator body. The metallized oscillator according to the present disclosure can avoid overflow plating, thereby improving the electrical performance of a circuit.

In an embodiment, the electroplating zone sequentially includes a nickel layer, a thin copper layer, a thick copper layer, a bright tin layer, a matt tin layer and a passivation film from inside to outside.

In an embodiment, the nickel layer has a thickness less than or equal to 1 µm; the thin copper layer is formed by electroplating acid copper on the nickel layer, and has a thickness greater than 1 µm and less than 3 µm; the thick copper layer includes a bright pyrophosphate copper layer and a pyrophosphate copper layer, and has a thickness greater than or equal to 8 µm; and the passivation film is formed by passivating the matt tin layer to provide tin protection for the oscillator body.

The embodiments described above are just illustrative implementations of the present disclosure and are not intended to limit the protection scope of the present disclosure.

Detailed description of embodiments of the present disclosure is provided by way of illustrative and non-limiting implementations. However, it will be apparent to those having ordinary skill in the art that various modifications and adjustments of the above embodiments may be made without departing from the scope of the present disclosure in connection with the drawings and claims. Therefore, the proper scope of the present disclosure will be determined according to the claims.

## Claims

1. A method for surface metallization of an oscillator, comprising:
electroplating copper with acid copper on a nickel layer in an electroplating zone of an oscillator body to form a thin copper layer in the electroplating zone;
etching the oscillator body to remove the nickel layer in a non-electroplating zone of the oscillator body;
electroplating copper on the thin copper layer in the electroplating zone to form a thick copper layer; and
electroplating tin on the thick copper layer in the electroplating zone to form a tin layer, and performing a tin protection process on the tin layer.

2. The method of claim 1, wherein electroplating copper on the thin copper layer in the electroplating zone to form a thick copper layer comprises:
electroplating bright pyrophosphate copper and pyrophosphate copper on the thin copper layer in the electroplating zone in sequence to form a bright pyrophosphate copper layer and a pyrophosphate copper layer, so that a thick copper layer consisted by the bright pyrophosphate copper layer and the pyrophosphate copper layer is formed, wherein the thick copper layer has a thickness greater than or equal to 8 µm.

3. The method of claim 1, wherein electroplating tin on the thick copper layer in the electroplating zone to form a tin layer comprises:
electroplating bright tin on the thick copper layer in the electroplating zone to form a bright tin layer; and
electroplating matt tin on the bright tin layer to form a matt tin layer.

4. The method of claim 3, wherein the tin protection process performed on the tin layer comprises:
passivating the matt tin layer to form a passivation film, so that the passivation film provides tin protection for the oscillator body.

5. The method of claim 1, wherein the thin copper layer has a thickness greater than 1 µm and less than 3 µm.

6. The method of claim 1, wherein before electroplating copper with acid copper on a nickel layer in an electroplating zone of an oscillator body to form a thin copper layer in the electroplating zone, the method further comprises:
obtaining an oscillator body by means of injection molding;
physically roughening the surface of the oscillator body, and cleaning the physically roughened oscillator body;
chemically roughening the surface of the oscillator body, and cleaning the chemically roughened oscillator body;
depositing palladium ions on the surface of the chemically roughened oscillator body;
plating nickel on the oscillator body to form a nickel layer on the surface of the oscillator body; and
lasing on the nickel layer to form a barrier line, so as to divide the surface of the oscillator body into an electroplating zone and a non-electroplating zone.

7. The method of claim 6, wherein cleaning the physically roughened oscillator body comprises:
cleaning the physically roughened oscillator body with ultrasonic wave, clean water and expansion agent in sequence.

8. The method of claim 6, wherein chemically roughening the oscillator body, and cleaning the chemically roughened oscillator body comprise:
weak-acidically micro-corroding and roughening the oscillator body in a chemical pool containing chromic acid and sulfuric acid; and
cleaning the chemically roughened oscillator body with alkaline potion.

9. The method of any one of claims 1-8, wherein the nickel layer has a thickness less than or equal to 1 µm.

10. A metallized oscillator, comprising:
an injection-molded oscillator body, and an electroplating zone and a non-electroplating zone on the surface of the oscillator body.

11. The oscillator of claim 10, wherein the electroplating zone sequentially comprises a nickel layer, a thin copper layer, a thick copper layer, a bright tin layer, a matt tin layer and a passivation film from inside to outside.

12. The oscillator of claim 11, wherein:
the nickel layer has a thickness less than or equal to 1 µm;
the thin copper layer is formed by electroplating acid copper on the nickel layer, and has a thickness greater than 1 µm and less than 3 µm;
the thick copper layer comprises a bright pyrophosphate copper layer and a pyrophosphate copper layer, and has a thickness greater than or equal to 8 µm; and
the passivation film is formed by passivating the matt tin layer to provide tin protection for the oscillator body.
